# EUROPEAN PATENT APPLICATION

(11) **EP 4 839 026 A1**
(43) Date of publication of application: **11.11.2026**
(21) Application number: 25738418.0
(22) Date of filing: 07.01.2025
(51) Int. Cl.: H05K 1/02

(54) **PROTECTIVE BOARD ASSEMBLY, BATTERY AND ELECTRIC DEVICE**

(30) Priority: 08.01.2024 CN 202410029609
(71) Applicant: Dongguan NVT Technology Limited, Dongguan City, Guangdong Province 523808 (CN)
(72) Inventor: HUANG, Xiaozhao, Dongguan, Guangdong 523808 (CN); OUYANG, Zhaohua, Dongguan, Guangdong 523808 (CN); NING, Shungang, Dongguan, Guangdong 523808 (CN)
(74) Representative: Icosa
(86) International application number: PCT/CN2025/071108
(87) International publication number: WO 2025/148888

(57) **Abstract**

A protection circuit module assembly, a battery, and an electrical device are provided. The protection circuit module assembly includes a first circuit board, a connector, a first electronic component, and an encapsulation member. The first circuit board includes a base portion and a first extension section connected to the base portion. The first extension section protrudes beyond the base portion, and the first extension section includes a first surface and a second surface disposed opposite to each other along a first arrangement direction. The connector is connected to the first surface, and is configured to be electrically connected to an external circuit. The first electronic component is connected to the second surface, and is configured to form a protection circuit. The encapsulation member is connected to the second surface and encapsulates the first electronic component. Along a first arrangement direction, a projection of the encapsulation member overlaps a projection of the connector. The protection circuit module assembly improves the energy density of a battery equipped with the protection circuit module assembly.

## Description

### TECHNICAL FIELD

This application relates to the technical field of energy storage, and in particular, to a protection circuit module assembly, a battery, and an electrical device.

### BACKGROUND

A battery includes a battery cell and a protection circuit module assembly disposed at the top of the battery cell. In existing protection board assemblies, most electronic components are mounted on a substrate, and on a circuit board that protrudes beyond the base, only a connector is placed. Consequently, the electronic components on the substrate occupy a large amount of space at the top of the battery cell, thereby reducing the energy density of the battery.

### SUMMARY

In view of the above situation, it is necessary to provide a protection circuit module assembly to improve the energy density of a battery equipped with the protection circuit module assembly.

An embodiment of this application provides a protection circuit module assembly. The protection circuit module assembly includes a first circuit board, a connector, a first electronic component, and an encapsulation member. The first circuit board includes a base portion and a first extension section connected to the base portion. The first extension section protrudes beyond the base portion, and the first extension section includes a first surface and a second surface disposed opposite to each other along a first arrangement direction. The connector is connected to the first surface. The first electronic component is connected to the second surface. The encapsulation member is connected to the second surface and encapsulates the first electronic component. Along a first arrangement direction, a projection of the encapsulation member overlaps a projection of the connector.

In the protection circuit module assembly, the connector is connected to the first surface and configured to be electrically connected to an external circuit. The first electronic component is connected to the second surface and configured to form a protection circuit. The encapsulation member is connected to the second surface and encapsulates the first electronic component. Along a first arrangement direction, a projection of the encapsulation member overlaps a projection of the connector. The encapsulation member can improve the structural strength of the first extension section at a position where the connector is disposed, thereby reducing the risk of damage to the first extension section caused by a force exerted in a process of connecting the connector to an external circuit. Moreover, when the connector is located within a main board compartment of the electrical device and is connected to a main board of the electrical device, the encapsulation member and the first electronic component within the encapsulation member are able to utilize the space within the main board compartment of the electrical device. In contrast to the conventional method in which most electronic components are disposed on the substrate, this arrangement reduces the space occupied by the electronic components at the top of the battery cell, and increases the energy density of the battery equipped with the protection circuit module assembly.

In some embodiments of this application, the protection circuit module assembly further includes a substrate. The substrate is connected to the base portion. One end of the first extension section is towards the substrate, and another end of the first extension section extends in a direction away from the substrate. In contrast to the conventional method in which most electronic components are disposed on the substrate, this application moves the encapsulation member and the first electronic component outward, thereby reducing the demand for the component-placement area on the substrate, and in turn, reducing the thickness of the substrate, and increasing the energy density of the battery equipped with the protection circuit module assembly.

In some embodiments of this application, the second surface includes a first region and a second region. Along the first arrangement direction, both the projection of the connector and the projection of the encapsulation member fall within a projection of the first region, so as to make the projection of the encapsulation member overlap the projection of the connector. The second region is located on one side of the first region, the one side of the first region being a side facing the substrate.

In some embodiments of this application, when viewed along the first arrangement direction, the encapsulation member includes an inner peripheral edge, the first region includes an outer peripheral edge, and the outer peripheral edge surrounds the inner peripheral edge. A spacing between the outer peripheral edge and the surrounded inner peripheral edge is 0.1 mm to 0.5 mm, so as to reduce the risk of an encapsulation material leaking out during processing, and to increase the space utilization rate of the encapsulation member within the first region.

In some embodiments of this application, the encapsulation member includes two first outer side surfaces and two second outer side surfaces. The two first outer side surfaces are disposed opposite to each other along a second arrangement direction. The two second outer side surfaces are disposed opposite to each other along a third arrangement direction. The first outer side surfaces and the second outer side surfaces are connected sequentially in tandem. The first arrangement direction, the second arrangement direction, and the third arrangement direction are perpendicular to each other; Along the second arrangement direction, a spacing between the two first outer side surfaces is 3 mm to 10 mm; and along the third arrangement direction, a spacing between the two second outer side surfaces is 2 mm to 10 mm, so as to facilitate encapsulating the first electronic component and adapt to the shape of the connector.

In some embodiments of this application, the encapsulation member further includes a third outer side surface. Along the first arrangement direction, the third outer side surface is located on one side of the first electronic component, the side of the first electronic component being facing away from the second surface. A spacing between an end surface, facing away from the second surface, of the first electronic component and the third outer side surface is 0.15 mm to 5 mm, thereby both improving the protective capability of the encapsulation member for the first electronic component and reducing the waste of space occupied by the encapsulation member in the first arrangement direction.

In some embodiments of this application, Shore hardness of the encapsulation member is greater than 40, so as to improve the effect of the encapsulation member in reinforcing the first extension section at a position where the connector is disposed.

In some embodiments of this application, the first electronic component includes at least one of an anti-counterfeiting chip, a capacitor, or a resistor. The anti-counterfeiting chip is configured to identify whether the battery cell connected to the connector is a standard-configuration battery cell.

In some embodiments of this application, the first circuit board further includes a second extension section. The base portion and the substrate are disposed opposite to each other. The second extension section is bent and connected between the substrate and the base portion. The first extension section is connected to one end of the base portion, the end of the base portion being an end facing away from the second extension section. In contrast to the substrate, the base portion is provided with a margin of movement. When the substrate and the main board of the electrical device wobble or are displaced, the base portion is able to bend relative to the substrate using the second extension section as a pivot point, thereby reducing the risk that the connector and the encapsulation member on the first extension section become detached from the main board compartment of the electrical device.

In some embodiments of this application, the substrate includes a second circuit board and a reinforcement board connected to the second circuit board. The second circuit board and the base portion are located on opposite sides of the reinforcement board respectively. The second circuit board and the first circuit board are integrally formed, so as to improve stability of the connection between the substrate and the first circuit board.

An embodiment of this application further provides a battery. The battery includes a battery cell and the protection circuit module assembly according to any one of the above embodiments. The protection circuit module assembly is disposed on one side of the battery cell and electrically connected to the battery cell. The first extension section extends in a direction away from the battery cell.

In some embodiments of this application, the battery cell includes an electrode assembly, a packaging pouch, and a tab. The packaging pouch includes a main portion and a sealing portion. The electrode assembly is accommodated in the main portion. The main portion includes a top wall. The sealing portion includes a first sealing edge. The first sealing edge is connected to the top wall and extends along a first direction. The first sealing edge and the top wall are disposed opposite to each other along a second direction. One end of the tab is electrically connected to the electrode assembly, and another end of the tab extends out from the first sealing edge. The first direction is a thickness direction of the battery cell, and the second direction is perpendicular to the first direction. The protection circuit module assembly further includes a substrate. The first circuit board is connected to the substrate. The substrate is located on a side of the first sealing edge, facing away from the top wall. The substrate and the first sealing edge are disposed opposite to each other along the second direction. The tab is connected to the substrate, thereby reducing the space occupied by the substrate at the top of the battery cell and increasing the energy density of the battery.

In some embodiments of this application, the protection circuit module assembly further includes a conductive member and a second electronic component. The conductive member and the second electronic component are connected to a side of the substrate, facing the first sealing edge. The conductive member is connected to the tab. The second electronic component and the conductive member are spaced apart from each other. The second electronic component is electrically connected to the first electronic component. The second electronic component and the first electronic component are configured to form a protection circuit. Along a thickness direction of the substrate, a height of the second electronic component is 0.1 mm to 0.3 mm, such that the electronic component of a relatively small height can utilize the height space of the conductive member in the second direction, thereby improving the space utilization rate between the substrate and the first sealing edge. Along the first arrangement direction, the height of the first electronic component is 0.4 mm to 0.8 mm, such that the electronic component of a relatively large height can utilize the space of a main board compartment of an electrical device, thereby reducing the space occupied by the electronic component at the top of the battery cell and increasing the energy density of the battery. In addition, by disposing the first electronic component and the second electronic component on the first circuit board and the substrate respectively, this application further reduces the risk of interference between the first electronic component and the second electronic component.

An embodiment of this application further provides an electrical device. The electrical device includes a main board and the battery disclosed in any one of the above embodiments. The connector is electrically connected to the main board, thereby further reducing the space occupied by the electronic components at the top of the battery cell. In addition, this arrangement reduces the demand for the component-placement area on the substrate, so as to reduce the thickness of the substrate, thereby increasing the energy density of the battery.

In some embodiments of this application, the electrical device further includes a third electronic component. The third electronic component is connected to the main board and electrically connected to the first electronic component. The third electronic component and the first electronic component are configured to form a protection circuit. In contrast to the conventional method in which most electronic components are disposed on the substrate, this arrangement reduces the space occupied by the electronic components at the top of the battery cell, and moreover, reduces the demand for the component-placement area on the substrate, thereby reducing the thickness of the substrate, and increasing the energy density of the battery.

In the protection circuit module assembly, battery, and electrical device, the connector is connected to the first surface and configured to be electrically connected to an external circuit. The first electronic component is connected to the second surface and configured to form a protection circuit. The encapsulation member is connected to the second surface and encapsulates the first electronic component. Along a first arrangement direction, a projection of the encapsulation member overlaps a projection of the connector. The encapsulation member can improve the structural strength of the first extension section at a position where the connector is disposed, thereby reducing the risk of damage to the first extension section caused by a force exerted in a process of connecting the connector to an external circuit. Moreover, when the connector is located within a main board compartment of the electrical device and is connected to a main board of the electrical device, the encapsulation member and the first electronic component within the encapsulation member are able to utilize the space within the main board compartment of the electrical device. In contrast to the conventional method in which most electronic components are disposed on the substrate, this arrangement reduces the space occupied by the electronic components at the top of the battery cell, and increases the energy density of the battery equipped with the protection circuit module assembly.

### BRIEF DESCRIPTION OF DRAWINGS

FIG. 1 is a schematic structural diagram of a protection circuit module assembly from a first viewing angle according to an embodiment of this application;
FIG. 2 is a schematic structural diagram of a protection circuit module assembly from a second viewing angle according to an embodiment of this application;
FIG. 3 is a schematic structural diagram of an encapsulation member of a protection circuit module assembly from a first viewing angle according to an embodiment of this application;
FIG. 4 is a schematic structural diagram of an encapsulation member of a protection circuit module assembly from a second viewing angle according to an embodiment of this application;
FIG. 5 is a schematic structural diagram of a battery according to an embodiment of this application;
FIG. 6 is a schematic structural diagram of an adhesive member in a battery according to an embodiment of this application;
FIG. 7 is a schematic structural diagram of an adhesive member in a battery according to another embodiment of this application;
FIG. 8 is a schematic structural diagram of a battery according to another embodiment of this application; and
FIG. 9 is a schematic structural diagram of an electrical device according to an embodiment of this application.

**List of reference signs**

| | |
|---|---|
| protection circuit module assembly | 100 |
| battery | 200 |
| electrical device | 300 |
| first circuit board | 10 |
| first extension section | 10a |
| second extension section | 10b |
| base portion | 10c |
| first surface | 11 |
| second surface | 12 |
| first region | 121 |
| outer peripheral edge | 121a |
| second region | 122 |
| first side edge | 13 |
| second side edge | 14 |
| third side edge | 15 |
| fourth side edge | 16 |
| extension line | L |
| fifth side edge | 17 |
| sixth side edge | 18 |
| connector | 20 |
| first electronic component | 31 |
| end surface | 311 |
| conductive member | 32 |
| second electronic component | 33 |
| third electronic component | 34 |
| first connector | 234 |
| encapsulation member | 40 |
| inner peripheral edge | 40a |
| first outer side surface | 41 |
| second outer side surface | 42 |
| third outer side surface | 43 |
| substrate | 50 |
| second circuit board | 51 |
| reinforcement board | 52 |
| battery cell | 60 |
| electrode assembly | 61 |
| packaging pouch | 62 |
| main portion | 621 |
| top wall | 621a |
| sealing portion | 622 |
| first sealing edge | 622a |
| tab | 63 |
| first adhesive member | 71 |
| first adhesive portion | 711 |
| second adhesive portion | 712 |
| gap | 713 |
| second adhesive member | 72 |
| main board | 80 |
| first arrangement direction | A |
| second arrangement direction | B |
| third arrangement direction | C |
| first direction | X |
| second direction | Z |
| third direction | Y |

This application is further described below with reference to the following specific embodiments and the foregoing drawings.

### DETAILED DESCRIPTION

The following describes the technical solutions in the embodiments of this application with reference to the drawings hereto. Evidently, the described embodiments are merely a part of but not all of the embodiments of this application.

It is noted that a component considered to be "connected to" another component may be directly connected to the other component or may be connected to the other component through an intermediate component. A component considered to be "disposed on" another component may be directly disposed on the other component or may be disposed on the other component through an intermediate component.

Unless otherwise defined, all technical and scientific terms used herein bear the same meanings as what is normally understood by a person skilled in the technical field of this application. The terms used in the specification of this application are merely intended to describe specific embodiments but not to limit this application. The term "and/or" used herein includes any and all combinations of one or more relevant items enumerated.

Understandably, in a technical solution of this application, considering the actual process tolerance, when two components are arranged parallel or perpendicular to each other along the same direction, an angle may exist between the two components. The angle between two components permits a tolerance of 0 to ±10%, and a measured value of the angle between the two components may be greater than, equal to, or less than the desired or nominal value with a tolerance of 0 to ±10%.

An embodiment of this application provides a protection circuit module assembly. The protection circuit module assembly includes a first circuit board, a connector, a first electronic component, and an encapsulation member. The first circuit board includes a base portion and a first extension section connected to the base portion. The first extension section protrudes beyond the base portion, and the first extension section includes a first surface and a second surface disposed opposite to each other along a first arrangement direction. The connector is connected to the first surface. The first electronic component is connected to the second surface. The encapsulation member is connected to the second surface and encapsulates the first electronic component. Along a first arrangement direction, a projection of the encapsulation member overlaps a projection of the connector.

In the protection circuit module assembly, the connector is connected to the first surface and configured to be electrically connected to an external circuit. The first electronic component is connected to the second surface and configured to form a protection circuit. The encapsulation member is connected to the second surface and encapsulates the first electronic component. Along a first arrangement direction, a projection of the encapsulation member overlaps a projection of the connector. The encapsulation member can improve the structural strength of the first extension section at a position where the connector is disposed, thereby reducing the risk of damage to the first extension section caused by a force exerted in a process of connecting the connector to an external circuit. Moreover, when the connector is located within a main board compartment of the electrical device and is connected to a main board of the electrical device, the encapsulation member and the first electronic component within the encapsulation member are able to utilize the space within the main board compartment of the electrical device. In contrast to the conventional method in which most electronic components are disposed on the substrate, this arrangement reduces the space occupied by the electronic components at the top of the battery cell, and increases the energy density of the battery equipped with the protection circuit module assembly.

The following further describes the embodiments of this application with reference to drawings.

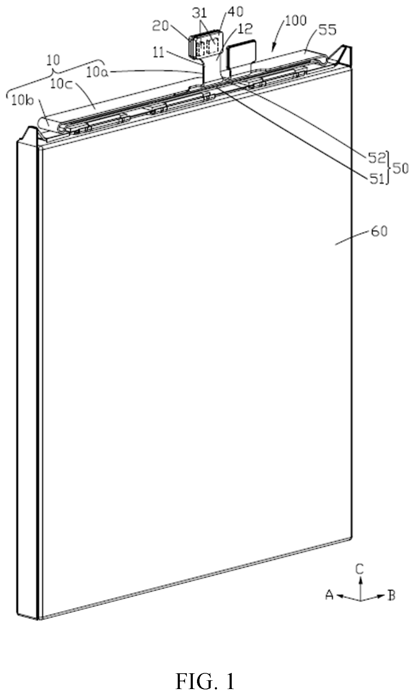

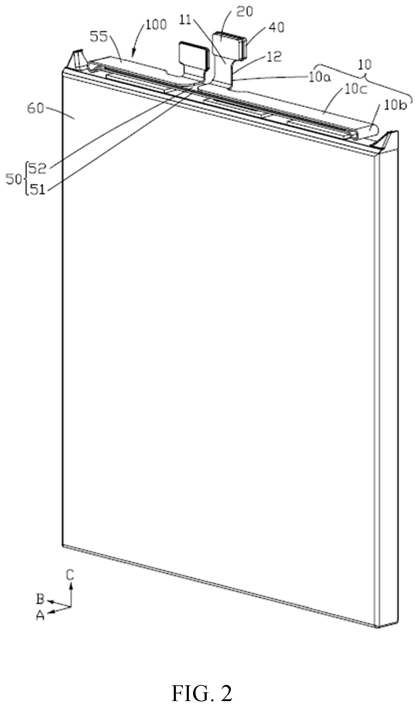

Referring to FIG. 1 and FIG. 2 together, an embodiment of this application provides a protection circuit module assembly 100. The protection circuit module assembly 100 is configured to protect a battery cell 60, for example, by performing voltage monitoring, current detection, temperature monitoring, insulation monitoring, and the like on the battery cell 60, so as to reduce the risk that the battery cell 60 enters a state of overcharging, overdischarging, overcurrent, short-circuiting, or charging/discharging at excessively high temperatures.

The protection circuit module assembly 100 includes a first circuit board 10, a connector 20, a first electronic component 31, and an encapsulation member 40. The first circuit board 10 is a flexible printed circuit (FPC). The FPC is a printed circuit made of a flexible insulating substrate material. A part of the first circuit board 10 is configured to be electrically connected to the battery cell 60, and another part of the first circuit board 10 is configured to extend into a main board compartment of an electrical device.

It is noted that the first circuit board 10 is electrically connected to the battery cell 60 through a substrate or another conductive member.

The first circuit board 10 includes a base portion 10c and a first extension section 10a connected to the base portion 10c. The first extension section 10a protrudes beyond the base portion 10c. An end of the first extension section 10a, which is far away from the base portion 10c, is configured to extend into the main board compartment of the electrical device. The first extension section 10a includes a first surface 11 and a second surface 12 disposed opposite to each other along a first arrangement direction A.

The connector 20 is connected to the first surface 11, and is configured to be electrically connected to an external circuit. The external circuit may be, but is not limited to, the main board of the electrical device.

The first electronic component 31 is connected to the second surface 12, and is configured to form a protection circuit. Specifically, the first electronic component 31 includes at least one of an anti-counterfeiting chip, a capacitor, or a resistor. The anti-counterfeiting chip is configured to identify whether the battery cell 60 connected to the connector 20 is a standard-configuration battery cell.

The encapsulation member 40 is connected to the second surface 12 and encapsulates the first electronic component 31. The encapsulation member 40 is configured to encapsulate the first electronic component 31 so as to form an encapsulation system to protect the first electronic component 31. Optionally, the encapsulation member 40 is formed from a resin material on the second surface 12 by injection molding, potting, or spraying.

Along a first arrangement direction A, a projection of the encapsulation member 40 overlaps a projection of the connector 20. This specifically includes the following scenarios: the projection of the encapsulation member 40 partially overlaps the projection of the connector 20; the projection of the encapsulation member 40 coincides the projection of the connector 20; or the projection of the connector 20 lies within the projection of the encapsulation member 40.

The encapsulation member 40 can improve the structural strength of the first extension section 10a at a position where the connector 20 is disposed, thereby reducing the risk of damage to the first extension section 10a caused by a force exerted in a process of connecting the connector 20 to an external circuit. Moreover, when the connector 20 is located within a main board compartment of the electrical device and is connected to a main board of the electrical device, the encapsulation member 40 and the first electronic component 31 within the encapsulation member 40 are able to utilize the space within the main board compartment of the electrical device. In contrast to the conventional method in which most electronic components are disposed on the substrate, this arrangement reduces the space occupied by the electronic components at the top of the battery cell 60, and increases the energy density of the battery equipped with the protection circuit module assembly 100.

In some embodiments, Shore hardness of the encapsulation member 40 is greater than 40, so as to improve the effect of the encapsulation member 40 in reinforcing the first extension section 10a at a position where the connector 20 is disposed.

Referring to FIG. 1 and FIG. 2 together, in some embodiments, the protection circuit module assembly further includes a substrate 50. The substrate 50 is disposed at the top of the battery cell 60 and is configured to be connected to the tab of the battery cell 60. The first circuit board 10 is electrically connected to the battery cell 60 by the substrate 50. The substrate 50 is connected to the base portion 10c. One end of the first extension section 10a is towards the substrate 50, and another end of the first extension section 10a extends in a direction away from the substrate 50, so as to extend into the main board compartment of the electrical device. In contrast to the conventional method in which most electronic components are disposed on the substrate, this application moves the encapsulation member 40 and the first electronic component 31 outward, thereby reducing the demand for the component-placement area on the substrate 50, and in turn, reducing the thickness of the substrate 50, and increasing the energy density of the battery equipped with the protection circuit module assembly 100.

In some embodiments, the base portion 10c and the substrate 50 are disposed opposite to each other. Of the two surfaces of the base portion 10c opposite to each other along the thickness direction, the surface on the side towards the substrate 50 is connected to the substrate 50.

In some embodiments, the substrate 50 includes a second circuit board 51 and a reinforcement board 52 connected to the second circuit board 51. The second circuit board 51 and the base portion 10c are located on opposite sides of the reinforcement board 52 respectively. The second circuit board 51 is an FPC. The second circuit board 51 and the first circuit board 10 are integrally formed, so as to improve the stability of the connection between the substrate 50 and the first circuit board 10.

Understandably, in other embodiments, the substrate 50 may be a printed circuit board or a rigid-flex board.

Referring to FIG. 1 and FIG. 2 together, in some embodiments, the first circuit board 10 further includes a second extension section 10b. The second extension section 10b is bent and connected between the substrate 50 and the base portion 10c. One end of the second extension section 10b is connected to the second circuit board 51. The first extension section 10a is connected to an end of the base portion 10c, the end of the base portion 10c being an end facing away from the second extension section 10b. In contrast to the substrate 50, the base portion 10c is provided with a margin of movement. When the substrate 50 and the main board of the electrical device wobble or are displaced, the base portion 10c is able to bend relative to the substrate 50 using the second extension section 10a as a pivot point, thereby reducing the risk that the connector 20 and the encapsulation member 40 on the first extension section 10a become detached from the main board compartment of the electrical device.

In some embodiments, the second circuit board 51 is integrally formed with the second extension section 10b, the base portion 10c, and the first extension section 10a in the first circuit board 10, thereby improving the stability of connection between the substrate 50 and the first circuit board 10.

In some embodiments, the protection circuit module assembly 100 further includes a third circuit board 55. The second extension section 10b is connected to one end of the substrate 50. The third circuit board 55 is connected to the other end of the substrate 50. Understandably, the structure of the third circuit board 55 is similar to that of the first circuit board 10. A connector, an electronic component, and an encapsulation member are disposed on the third circuit board 55, the details of which are omitted here.

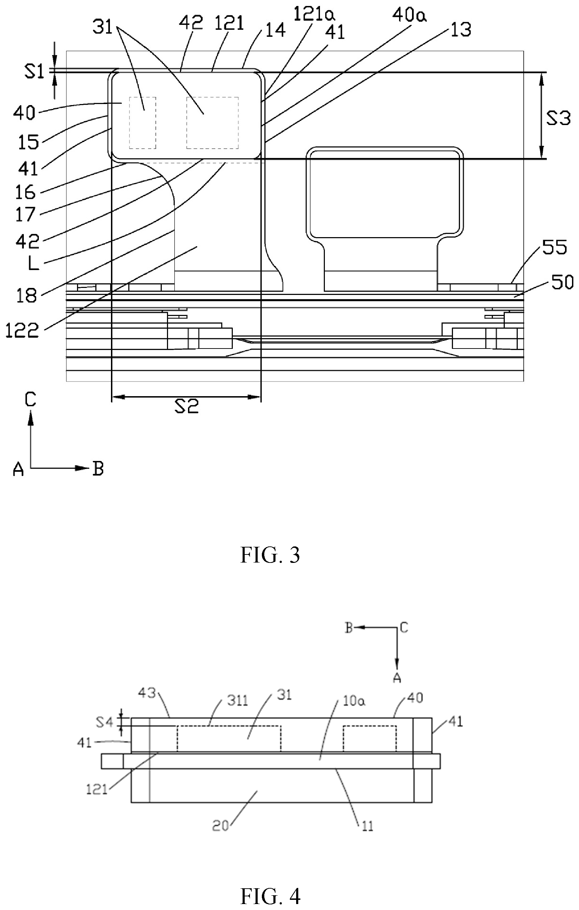

Also referring to FIG. 3, in some embodiments, the second surface 12 includes a first region 121 and a second region 122. Along the first arrangement direction A, both the projection of the connector 20 and the projection of the encapsulation member 40 fall within a projection of the first region 121, so as to make the projection of the encapsulation member 40 overlap the projection of the connector 20. The second region 122 is located on one side of the first region 121, the one side of the first region 121 being a side facing the substrate 50.

Specifically, when viewed along the first arrangement direction A, the first extension section 10a includes a first side edge 13, a second side edge 14, a third side edge 15, a fourth side edge 16, a fifth side edge 17, and a sixth side edge 18. The second side edge 14 is far away from the substrate 50 in the extension direction of the first extension section 10a. The first side edge 13 is connected to one side of the second side edge 14 in the second arrangement direction B. The third side edge 15, the fourth side edge 16, the fifth side edge 17, and the sixth side edge 18 are disposed on the other side of the second side edge 14 in a second arrangement direction B.

The third side edge 15 is connected to the second side edge 14 and is parallel to the first side edge 13 along the second arrangement direction B. The fourth side edge 16 is connected to the third side edge 15 and is parallel to the second side edge 14 along a third arrangement direction C. An end of the fourth side edge 16, which is far away from the third side edge 15, is spaced apart from the first side edge 13. The first arrangement direction A, the second arrangement direction B, and the third arrangement direction C are perpendicular to each other. The fifth side edge 17 is connected between the fourth side edge 16 and the sixth side edge 18 and extends in an arcuate manner. The sixth side edge 18 is parallel to the first side edge 13 along the second arrangement direction B. Along the second arrangement direction B, a spacing between the sixth side edge 18 and the first side edge 13 is smaller than a spacing between the third side edge 15 and the first side edge 13. On the second surface 12, bounded by an extension line L of the fourth side edge 16 toward the first side edge 13, a region between the fourth side edge 16 and the second side edge 14 is a first region 121, and a region of the fourth side edge 16 on one side facing away from the second side edge 14 is a second region 122.

Still referring to FIG. 3, when viewed along the first arrangement direction A, the encapsulation member 40 includes an inner peripheral edge 40a, the first region 121 includes an outer peripheral edge 121a, and the outer peripheral edge 121a surrounds the inner peripheral edge 40a. The outer peripheral edge 121a specifically includes a second side edge 14, a third side edge 15, a fourth side edge 16 and an extension line L thereof, and a part, parallel to the third side edge 15, of the first side edge 13.

A protection region is formed between the outer peripheral edge 121a and the inner peripheral edge 40a. A spacing S1 between the outer peripheral edge 121a and the inner peripheral edge 40a is 0.1 mm to 0.5 mm, so as to reduce the risk of an encapsulation material leaking out during processing, and to increase the space utilization rate of the encapsulation member 40 within the first region 121.

Optionally, the spacing S1 between the outer peripheral edge 121a and the inner peripheral edge 40a may be 0.1 mm, 0.15 mm, 0.2 mm, 0.25 mm, 0.3 mm, 0.35 mm, 0.4 mm, 0.45 mm, 0.5 mm, or any other value falling within the range of 0.1 mm to 0.5 mm.

Further, the spacing S1 between the outer peripheral edge 121a and the inner peripheral edge 40a is 0.15 mm to 0.25 mm, so as to further reduce the risk of an encapsulation material leaking out during processing, and to increase the space utilization rate of the encapsulation member 40 within the first region 121.

Still referring to FIG. 3, in some embodiments, the encapsulation member 40 includes two first outer side surfaces 41 and two second outer side surfaces 42. The two first outer side surfaces 41 are disposed opposite to each other along a second arrangement direction B. The two second outer side surfaces 42 are disposed opposite to each other along a third arrangement direction C. The first outer side surfaces 41 and the second outer side surfaces 42 are connected sequentially in tandem. Along the second arrangement direction B, a spacing S2 between the two first outer side surfaces 41 is 3 mm to 10 mm; and along the third arrangement direction C, a spacing S3 between the two second outer side surfaces 42 is 2 mm to 10 mm, so as to facilitate encapsulating the first electronic component 31 and adapt to the shape of the connector 20.

Optionally, the spacing S2 between the two first outer side surfaces 41 may be 3 mm, 3.5 mm, 4 mm, 4.5 mm, 5 mm, 5.5 mm, 6 mm, 6.5 mm, 7 mm, 7.5 mm, 8 mm, 8.5 mm, 9 mm, 9.5 mm, 10 mm, or any other value within the range of 3 mm to 10 mm. Optionally, the spacing S3 between the two second outer side surfaces 42 may be 2 mm, 2.5 mm, 3 mm, 3.5 mm, 4 mm, 4.5 mm, 5 mm, 5.5 mm, 6 mm, 6.5 mm, 7 mm, 7.5 mm, 8 mm, 8.5 mm, 9 mm, 9.5 mm, 10 mm, or any other value within the range of 2 mm to 10 mm.

Further, the spacing S2 between the two first outer side surfaces 41 is 5 mm to 7 mm, and the spacing S3 between the two second outer side surfaces 42 is 3 mm to 4 mm, so as to further facilitate encapsulating the first electronic component 31 and adapt to the shape of the connector 20.

Also referring to FIG. 4, in some embodiments, the encapsulation member 40 further includes a third outer side surface 43. Along the first arrangement direction A, the third outer side surface 43 is located on one side of the first electronic component 31, the side of the first electronic component 31 being facing away from the second surface 12. The first outer side surface 41 and the second outer side surface 42 are each connected to the third outer side surface 43. The spacing S4 between an end surface 311 facing away from the second surface of the first electronic component 31 and the third outer side surface 43 is 0.15 mm to 5 mm. When S4 is excessively small (less than 0.15 mm), the encapsulation thickness of the encapsulation member 40 is prone to be excessively thin, resulting in weak protection for the end surface 311 facing away from the second surface of the first electronic component 31. When S4 is excessively large (greater than 5 mm), the encapsulation member 40 is prone to occupy a large amount of space in the first arrangement direction A, resulting in a waste of space. By defining S4 to fall within the range of 0.15 mm to 5 mm, this application improves the protective capability of the encapsulation member 40 for the first electronic component 31 and reduces the waste of space occupied by the encapsulation member 40 in the first arrangement direction A.

Optionally, the spacing S4 between the end surface 311 facing away from the second surface, of the first electronic component 31 and the third outer side surface 43 may be one of 0.15 mm, 2 mm, 2.5 mm, 3 mm, 3.5 mm, 4 mm, 4.5 mm, 5 mm, or any other value falling within the range of 0.15 mm to 5 mm.

Further, the spacing S4 between an end surface 311 facing away from the second surface of the first electronic component 31 and the third outer side surface 43 is 0.15 mm to 2.5 mm, so as to further improve the protective capability for the first electronic component 31, and reduce the waste of space occupied by the encapsulation member 40 in the first arrangement direction A.

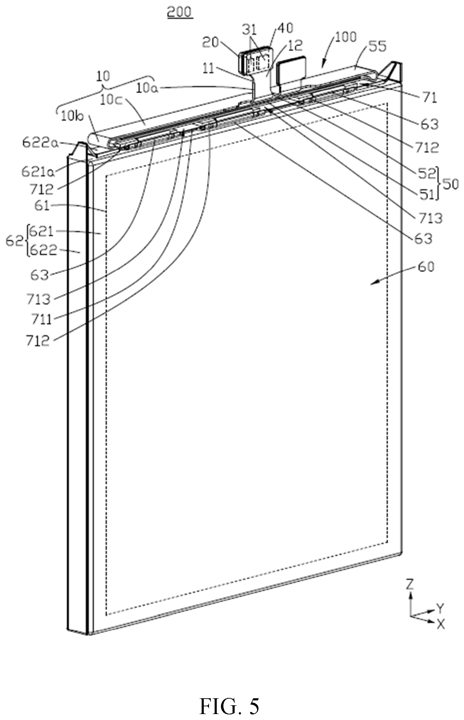

Referring to FIG. 5, an embodiment of this application further provides a battery 200. The battery 200 includes a battery cell 60 and any one of the protection circuit module assemblies 100 disclosed the above embodiments. The first extension section 10a extends in a direction away from the battery cell 60. The battery 200 may be, but is not limited to, a secondary battery. The secondary battery is a battery that is reusable through activation of an active material in the battery by charging the battery that is discharged.

In some embodiments, the battery cell 60 includes an electrode assembly 61, a packaging pouch 62, and a tab 63. The electrode assembly 61 is configured to convert chemical energy into electrical energy. Specifically, the electrode assembly 61 includes a positive electrode plate, a separator, and a negative electrode plate disposed in sequence. Optionally, the positive electrode plate, the separator, and the negative electrode plate are a winding-type structure or a stacked-type structure.

The packaging pouch 62 includes a main portion 621 and a sealing portion 622. The electrode assembly 61 is accommodated in the main portion 621. The sealing portion 622 is configured to seal the main portion 621. Optionally, the packaging pouch 62 is formed by folding an aluminum laminated film. The main portion 621 is a portion, provided with a recess, of the aluminum laminated film. The sealing portion 622 is a portion at which the aluminum laminated films overlap.

The main portion 621 includes a top wall 621a, and the sealing portion 622 includes a first sealing edge 622a. The first sealing edge 622a is connected to the top wall 621a and extends along a first direction X. The first sealing edge 622a and the top wall 621a are disposed opposite to each other along a second direction Z. One end of the tab 63 is electrically connected to the electrode assembly 61, and another end of the tab 63 extends out from the first sealing edge 622a. The first direction X is a thickness direction of the battery cell 60, and the second direction Z is perpendicular to the first direction X. Optionally, the second direction Z is a length direction of the battery cell 60.

In some embodiments, a plurality of tabs 63 are provided and arranged along a third direction Y. The third direction Y, the second direction Z, and the first direction X are perpendicular to each other. Optionally, the third direction Y is a width direction of the battery cell 60.

The substrate 50 is located on a side of the first sealing edge 622a, facing away from the top wall 621a The substrate 50 and the first sealing edge 622a are disposed opposite to each other along the second direction Z. The tab 63 is further connected to the substrate 50, thereby reducing the space occupied by the substrate 50 at the top of the battery cell 60 in the second direction Z and increasing the energy density of the battery 200.

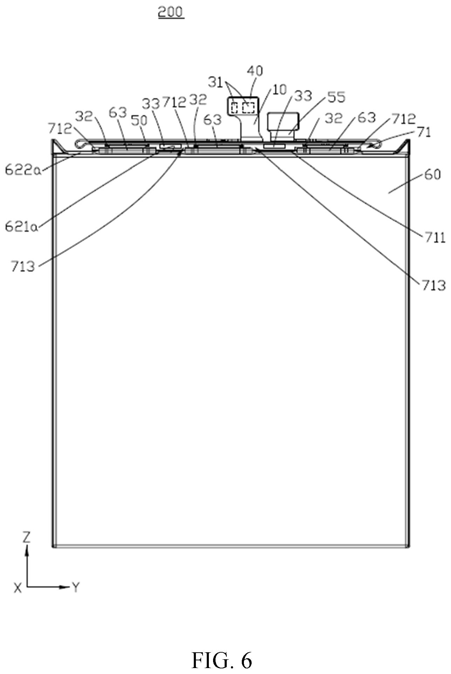

Still referring to FIG. 6, in some embodiments, the protection circuit module assembly 100 further includes a conductive member 32 and a second electronic component 33. The conductive member 32 and the second electronic component 33 are connected to a side of the substrate 50, facing the first sealing edge 622a, so as to reduce the risk of the conductive member 32 and the second electronic component 33 being subjected to external impact. The conductive member 32 is connected to the tab 63, so as to electrically connect the substrate 50 to the battery cell 60.

The second electronic component 33 and the conductive member 32 are spaced apart from each other. The second electronic component 33 is electrically connected to the first electronic component 31. The second electronic component 33 and the first electronic component 31 are configured to form a protection circuit. Along a thickness direction (that is, the second direction Z) of the substrate 50, a height of the second electronic component 33 is 0.1 mm to 0.3 mm, such that the electronic component of a relatively small height can utilize the height space of the conductive member 32 in the second direction Z, thereby improving the space utilization rate between the substrate 50 and the first sealing edge 622a. Along the first arrangement direction A, the height of the first electronic component 31 is 0.4 mm to 0.8 mm, such that the electronic component of a relatively large height can utilize the space of a main board compartment of an electrical device, thereby reducing the space occupied by the electronic component at the top of the battery cell 60 and increasing the energy density of the battery 200. In addition, by disposing the first electronic component 31 and the second electronic component 33 on the first circuit board 10 and the substrate 50 respectively, this application further reduces the risk of interference between the first electronic component 31 and the second electronic component 33.

Referring to FIG. 5 and FIG. 6 together, in some embodiments, the conductive member 32 is a U-shaped nickel sheet. One end of the tab 63 extends into the conductive member 32 and is connected to the conductive member 32. The battery 200 further includes a first adhesive member 71. The first adhesive member 71 is connected between one side, facing away from the substrate 50, of the conductive member 32 and the first sealing edge 622a, so as to improve the stability of the substrate 50 at the top of the battery cell 60.

In some embodiments, the first adhesive member 71 includes a first adhesive portion 711 and a plurality of second adhesive portions 712 disposed protrusively on one side of the first adhesive portion 711. One side of the first adhesive portion 711, which faces away from the second adhesive portion 712, is bonded to one side, facing the substrate 50, of the first sealing edge 622a. One side, facing away from the first adhesive portion 711, of the second adhesive portion 712 is bonded to one side, facing away from the substrate 50, of the conductive member 32. The second adhesive portion 712 supports the substrate 50 through the conductive member 32, such that a clearance 713 is formed between the substrate 50 and a region of the first adhesive portion 711, the region being provided with no second adhesive portion 712. It is noted that, when viewed along the first direction X, the clearance 713 is formed between two adjacent second adhesive portions 712, and/or formed on one side of the outermost second adhesive portion 712, the side facing away from an adjacent second adhesive portion 712.

Along the second direction Z, a projection of the second electronic component 33 lies within a projection of the first adhesive member 71 and does not overlap a projection of the second adhesive portion 712, so that the clearance 713 serves as an accommodation space for the second electronic component 33, thereby facilitating an increase in the upper limit of the height of the second electronic component 33 disposed between the substrate 50 and the first sealing edge 622a, and facilitating component placement on the substrate 50.

Optionally, three conductive members 32 and three second adhesive portions 712 are provided. The three second adhesive portions 712 are arranged at intervals along the third direction Y on one side of the first adhesive portion 711.

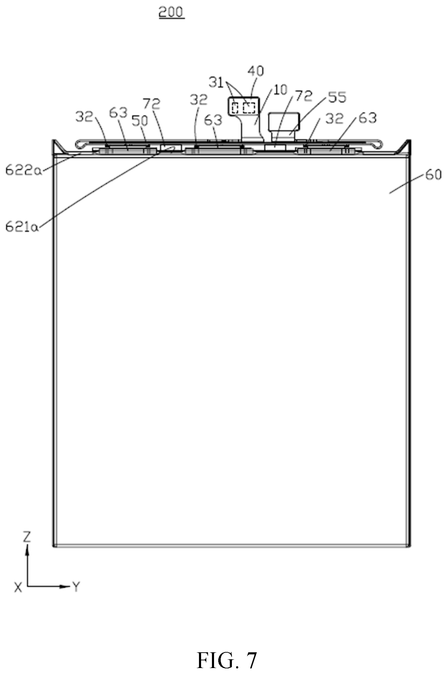

Referring to FIG. 7, in some embodiments, the second adhesive member 72 is connected to one side of the substrate 50, facing the first sealing edge 622a. The second adhesive member 72 and the conductive member 32 are spaced apart from each other. One side of the second adhesive member 72, which is far away from the substrate 50, is connected to the first sealing edge 622a, so as to improve the stability of the substrate 50 at the top of the battery cell 60. Moreover, the second adhesive member 72 utilizes the space vacated on the substrate 50 by moving out the first electronic component 31, thereby reducing the space occupied by the second adhesive member 72 at the top of the battery cell 60, and in turn, increasing the energy density of the battery 200.

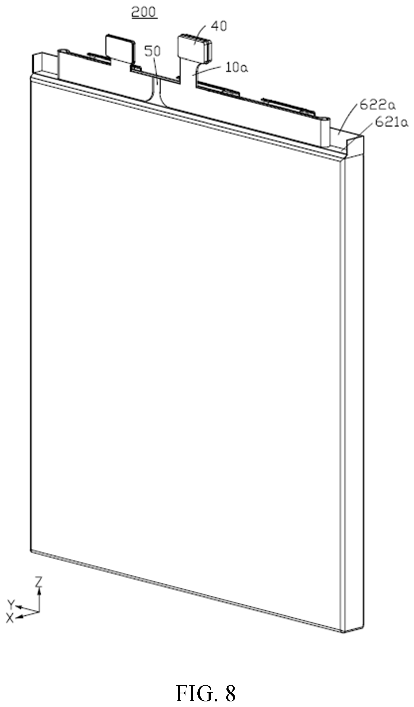

Referring to FIG. 8, in some embodiments, the first sealing edge 622a is connected to the top wall 621a and extends along the second direction Z. The first sealing edge 622a and the substrate 50 are disposed opposite to each other along the first direction X. Understandably, the positional relationship between the first sealing edge 622a and the substrate 50 is similar, the details of which are omitted here.

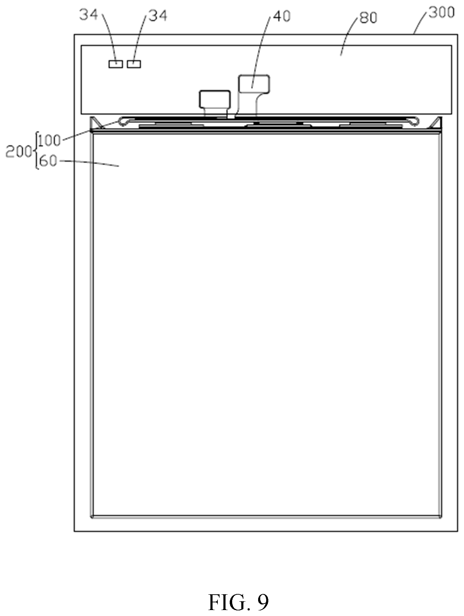

Referring to FIG. 9, an embodiment of this application further provides an electrical device 300. The electrical device includes a main board 80 and the battery 200 disposed in any one of the above embodiments. The connector 20 is electrically connected to the main board 80, so as to electrically connect the battery cell 60 to the main board 80. The electrical device 300 may be, but is not limited to, an electronic terminal such as a mobile phone, a tablet, a camera, an unmanned aerial vehicle, or the like.

In some embodiments, the electrical device 300 includes a third electronic component 34. The third electronic component 34 is connected to the main board 80 and electrically connected to the first electronic component 31. The third electronic component 34 and the first electronic component 31 are configured to form a protection circuit, so as to reduce the space occupied by the electronic components at the top of the battery cell 60, and moreover, reduce the demand for the component-placement area on the substrate 50, thereby reducing the thickness of the substrate 50, and increasing the energy density of the battery 200.

In some embodiments, the encapsulation member 40 is in contact with an external structural member, such as a wall of a main board compartment of the electrical device 300, so as to facilitate the transfer of heat from the first circuit board 10 and the first electronic component 31 to the external structural member, thereby reducing the temperature rise of the first circuit board 10 and the first electronic component 31.

In summary, in the protection circuit module assembly 100, battery 200, and electrical device 300, the connector 20 is connected to the first surface 11 and configured to be electrically connected to an external circuit. The first electronic component 31 is connected to the second surface 12 and configured to form a protection circuit. The encapsulation member 40 is connected to the second surface 12 and encapsulates the first electronic component 31. Along a first arrangement direction A, a projection of the encapsulation member 40 overlaps a projection of the connector 20. The encapsulation member 40 can improve the structural strength of the first extension section 10a at a position where the connector 20 is disposed, thereby reducing the risk of damage to the first extension section 10a caused by a force exerted in a process of connecting the connector 20 to an external circuit. Moreover, when the connector 20 is located within a main board compartment of the electrical device and is connected to a main board of the electrical device, the encapsulation member 40 and the first electronic component 31 within the encapsulation member 40 are able to utilize the space within the main board compartment of the electrical device. In contrast to the conventional method in which most electronic components are disposed on the substrate, this arrangement reduces the space occupied by the electronic components at the top of the battery cell 60, and increases the energy density of the battery equipped with the protection circuit module assembly 100.

In addition, a person skilled in the art may make other variations to this application without departing from the essence of this application. The variations made based on the essence of this application still fall within the protection scope of this application.

## Claims

1. A protection circuit module assembly, **characterized in that** the protection circuit module assembly comprises:
a first circuit board, comprising a base portion and a first extension section connected to the base portion, wherein the first extension section protrudes beyond the base portion, and the first extension section comprises a first surface and a second surface disposed opposite to each other along a first arrangement direction;
a connector, connected to the first surface;
a first electronic component, connected to the second surface; and
an encapsulation member, connected to the second surface and encapsulating the first electronic component, wherein along the first arrangement direction, a projection of the encapsulation member overlaps a projection of the connector.

2. The protection circuit module assembly according to claim 1, **characterized in that** the protection circuit module assembly further comprises a substrate, the substrate is connected to the base portion, one end of the first extension section is towards the substrate, and another end of the first extension section extends in a direction away from the substrate.

3. The protection circuit module assembly according to claim 2, **characterized in that** the second surface comprises a first region and a second region; along the first arrangement direction, both the projection of the connector and the projection of the encapsulation member fall within a projection of the first region, and the second region is located on one side of the first region, the one side of the first region being a side facing the substrate.

4. The protection circuit module assembly according to claim 3, **characterized in that**, when viewed along the first arrangement direction, the encapsulation member comprises an inner peripheral edge, the first region comprises an outer peripheral edge, the outer peripheral edge surrounds the inner peripheral edge, and a spacing between the outer peripheral edge and the surrounded inner peripheral edge is 0.1 mm to 0.5 mm.

5. The protection circuit module assembly according to claim 1, **characterized in that** the encapsulation member comprises two first outer side surfaces and two second outer side surfaces, the two first outer side surfaces are disposed opposite to each other along a second arrangement direction, the two second outer side surfaces are disposed opposite to each other along a third arrangement direction, the first outer side surfaces and the second outer side surfaces are connected sequentially in tandem, and the first arrangement direction, the second arrangement direction, and the third arrangement direction are perpendicular to each other;
along the second arrangement direction, a spacing between the two first outer side surfaces is 3 mm to 10 mm; and
along the third arrangement direction, a spacing between the two second outer side surfaces is 2 mm to 10 mm.

6. The protection circuit module assembly according to claim 1, **characterized in that** the encapsulation member further comprises a third outer side surface; along the first arrangement direction, the third outer side surface is located on one side of the first electronic component, the one side of the first electronic component being a side facing away from the second surface; and a spacing between an end surface of the first electronic component and the third outer side surface is 0.15 mm to 5 mm, the end surface of the first electronic component being an end facing away from the second surface .

7. The protection circuit module assembly according to claim 1, **characterized in that** Shore hardness of the encapsulation member is greater than 40.

8. The protection circuit module assembly according to claim 1, **characterized in that** the first electronic component comprises at least one of an anti-counterfeiting chip, a capacitor, or a resistor.

9. The protection circuit module assembly according to claim 2, **characterized in that** the first circuit board further comprises a second extension section, the base portion and the substrate are disposed opposite to each other, the second extension section is bent and connected between the substrate and the base portion, and the first extension section is connected to one end of the base portion, the one end of the base portion being an end facing away from the second extension section.

10. The protection circuit module assembly according to claim 2, **characterized in that** the substrate comprises a second circuit board and a reinforcement board connected to the second circuit board, the second circuit board and the base portion are located on opposite sides of the reinforcement board respectively, and the second circuit board and the first circuit board are integrally formed.

11. A battery, **characterized in that** the battery comprises a battery cell and the protection circuit module assembly according to any one of claims 1 to 10, the protection circuit module assembly is disposed on one side of the battery cell and electrically connected to the battery cell, and the first extension section extends in a direction away from the battery cell.

12. The battery according to claim 11, **characterized in that** the battery cell comprises an electrode assembly, a packaging pouch, and a tab; the packaging pouch comprises a main portion and a sealing portion; the electrode assembly is accommodated in the main portion; the main portion comprises a top wall; the sealing portion comprises a first sealing edge; the first sealing edge is connected to the top wall and extends along a first direction; the first sealing edge and the top wall are disposed opposite to each other along a second direction;; one end of the tab is electrically connected to the electrode assembly, and another end of the tab extends out from the first sealing edge; the first direction is a thickness direction of the battery cell, and the second direction is perpendicular to the first direction; and
the protection circuit module assembly further comprises a substrate, the first circuit board is connected to the substrate, the substrate is located on a side of the first sealing edge facing away from the top wall, the substrate and the first sealing edge are disposed opposite to each other along the second direction, and the tab is connected to the substrate.

13. The battery according to claim 12, **characterized in that** the protection circuit module assembly further comprises a conductive member and a second electronic component, the conductive member and the second electronic component are connected to a side of the substrate facing the first sealing edge, the conductive member is connected to the tab, the second electronic component and the conductive member are spaced apart from each other, and the second electronic component is electrically connected to the first electronic component;
along a thickness direction of the substrate, a height of the second electronic component is 0.1 mm to 0.3 mm; and
along the first arrangement direction, a height of the first electronic component is 0.4 mm to 0.8 mm.

14. An electrical device, **characterized in that** the electrical device comprises a main board and the battery according to any one of claims 11 to 13, and the connector is electrically connected to the main board.

15. The electrical device according to claim 14, **characterized in that** the electrical device comprises a third electronic component, and the third electronic component is connected to the main board and electrically connected to the first electronic component.
